# EUROPEAN PATENT APPLICATION

(11) **EP 1 026 823 A2**
(43) Date of publication of application: **09.08.2000**
(21) Application number: 00400332.3
(22) Date of filing: 08.02.2000
(51) Int. Cl.: H03H 9/02

(54) **Surface acoustic wave device having a resinous film to cover an electrode pattern**

(30) Priority: 08.02.1999 JP 3024899
(71) Applicant: Murata Manufacturing Co., Ltd., Nagaokakyo-shi Kyoto-fu 617-8555 (JP)
(72) Inventor: Kadota, Michio, Murata Manufacturing Co., Ltd., Kyoto-fu 617-8555 (JP); Ago, Junya, Murata Manufacturing Co., Ltd., Kyoto-fu 617-8555 (JP); Horiuchi, Hideya, Murata Manufacturing Co., Ltd., Kyoto-fu 617-8555 (JP)
(74) Representative: Orian, Yvette Suzanne

(57) **Abstract**

An shear horizontal type surface acoustic wave device includes a piezoelectric substrate (2), an electrode pattern having at least one interdigital transducer (5) located on the piezoelectric substrate, and a resinous film (11) located on an entire area of a surface of the piezoelectric substrate except for a portion of a lead electrode (3c,4c) of the electrode pattern. The resinous film (11) is preferably formed by screen printing. The resinous film (11) includes a mixture of insulating powder having a specific gravity of not more than about 1.0, and a resin having a Shore hardness of not more than about 30.

## Description

### BACKGROUND OF THE INVENTION

### 1. Field of the Invention

The present invention relates to a surface acoustic wave device and a method of forming such a device, in which a resinous film is arranged so as to cover an electrode pattern located on a piezoelectric substrate.

### 2. Description of the Related Art

Conventional shear horizontal (SH) type surface acoustic wave devices have a resinous film located on a surface provided with an interdigital transducer. For example, U.S. Patent No.5,260,913 and Japanese Unexamined Patent Publication No. 5-152888 disclose such a device. The resinous film provides mechanical protection and prevention against short circuiting caused by metal powder or the like, for an electrode pattern of the interdigital transducer and other element located on the piezoelectric substrate, or prevention of bulk waves and unnecessary reflected waves (surface acoustic waves) at edges of the surface acoustic wave device. In order to reduce attenuation of necessary surface acoustic waves caused by the resinous films, conventionally, low viscosity resinous materials, such as a gel resin or a resin having a low Shore hardness, are used, and the resinous films of the resinous materials are formed by potting using a dispenser or other suitable apparatus. Lead electrodes are disposed at parts of the interdigital transducer, and connecting wires for input and output to the device are bonded to the lead electrodes.

The surface acoustic wave devices described above are generally produced by cutting a piezoelectric parent substrate having a plurality of surface acoustic wave devices thereon, using a cutting tool, such as a dicer. Each independent device produced by the cutting is put into a housing which includes a base portion and a cap portion. Alternatively, each independent device is coated by a protective coating resin so as to cover critical portions thereof except for the lead terminals.

However, in conventional surface acoustic wave devices described above, since resinous films are formed by potting using dispensers, there is a problem in that the cost for forming the resinous films is high. In addition, there are problems in that resinous films are difficult to form selectively at desired locations on piezoelectric substrates since conventional resinous materials have low viscosity, and the manufacturing cost is therefore high.

That is, since resinous films are difficult to form on the piezoelectric substrate so as to expose only the lead electrode portions, resinous films must be formed after wire bonding on individual separate piezoelectric substrates which are placed on base substrates, and productivity is therefore seriously lowered.

Due to the problems described above, formation of resinous films using resinous materials in which the viscosity was increased by mixing a gel resin with insulating powder was proposed. However, when insulating powder having a high specific gravity is mixed, necessary surface waves are also suppressed, so that there are problems in that desired resonance characteristics and filter characteristics cannot be obtained.

### SUMMARY OF THE INVENTION

To overcome the problems described above, preferred embodiments of the present invention provide a shear horizontal type surface acoustic wave device having superior characteristics and in which the cost for forming the resinous film and the cost for manufacturing the surface acoustic wave device is greatly reduced.

According to one preferred embodiment of the present invention, an SH type surface acoustic wave device preferably includes a piezoelectric substrate, an electrode pattern having at least one interdigital transducer located on the piezoelectric substrate, and a screen-printed resinous film arranged on an entire surface of the piezoelectric substrate except for a location of a lead electrode of the electrode pattern. The resinous film preferably includes a mixture of insulating powder having a specific gravity (d) of not more than about 1.0, and a resin having a Shore hardness of not more than about 30.

According to another preferred embodiment of the present invention, a method of forming a surface acoustic wave device includes the steps of providing a parent substrate, forming a plurality of interdigital transducers on the parent substrate, forming a resin film on a surface of the parent substrate except at locations of lead electrodes of the electrode pattern, the step of forming a resin film including screen printing the resin film on the surface of the parent substrate, and cutting the parent substrate to form a plurality of independent surface acoustic wave devices.

According to this unique structure and method, since resinous films are formed by screen printing, resinous films for a plurality of surface acoustic wave devices are formed simultaneously. Consequently, the costs for forming resinous films are reduced, the manufacturing process is also greatly simplified, and the costs for manufacturing surface acoustic wave devices are therefore reduced.

When a resinous film including insulating powder which is mixed with a resin and having a specific gravity of not more than about 1.0 is used in preferred embodiments of the present invention, degradation of performance and device characteristics caused by the resinous film are avoided. In addition, unnecessary surface waves are suppressed by such a resinous film and therefore, superior characteristics of the surface acoustic wave device are achieved.

For the purpose of illustrating the invention, there are shown in the drawings several forms which are presently preferred, it being understood, however, that the invention is not limited to the precise arrangements and instrumentalities shown.

### BRIEF DESCRIPTION OF THE DRAWINGS

Fig. 1 is a perspective view of a surface acoustic wave device of a preferred embodiment according to the present invention.

Fig. 2 is a cross-sectional view taken along line X-X of the surface acoustic wave device shown in Fig. 1.

Fig. 3 is a graph showing frequency characteristics of longitudinally coupled surface acoustic wave filters according to preferred embodiments of the present invention and a comparative example.

Fig. 4 is a graph showing resonance characteristics of surface acoustic wave resonators according to preferred embodiments of the present invention and a comparative example.

Fig. 5 shows the relationship between the specific gravity of the insulating powder and the impedance ratio of the surface acoustic wave resonator having a resinous film in which the insulating powder is dispersed.

Fig. 6 shows the relationship between relationship between the specific gravity of the insulating powder and the insertion loss of the surface acoustic wave filter having a resinous film in which the insulating powder is dispersed.

### DETAILED DESCRIPTION OF PREFERRED EMBODIMENTS

An SH type surface acoustic wave device according to a preferred embodiment of the present invention preferably includes a piezoelectric substrate and an electrode pattern having at least one interdigital transducer provided on the piezoelectric substrate. In the surface acoustic wave device, a resinous film is preferably formed by screen printing on the piezoelectric substrate except at locations of lead electrodes of the electrode pattern. The resinous film preferably includes a mixture of insulating powder having a specific gravity (d) of not more than about 1.0 with a gel resin or a resin having a Shore hardness of not more than about 30.

According to preferred embodiments of the present invention, a resin having low viscosity is preferably mixed with insulating powder so as to have higher viscosity, which can be used for screen printing, and the resinous film of this resinous material is formed on the piezoelectric substrate by screen printing. In addition, insulating powder to be mixed preferably has a specific gravity of not more than about 1.0 so as not to degrade the properties thereof due to the resinous film. A resinous material to be used may be a silicone resin, an urethane resin, an epoxy resin, a polyester resin, or a polyimide resin as a primary ingredient, and preferably has a Shore hardness of not more than about 30. Silica, aluminum oxide, titanium oxide, carbon black, silica aerogel, or other suitable material having a specific gravity of not more than about 1.0, is used as insulating powder.

According to the arrangement described above, the cost for forming resinous films is markedly reduced by screen printing the resinous films instead of forming the resinous films by conventional potting. In addition, resinous films can be formed on the substrate except at locations of the lead electrode portions of the electrode pattern. Also, one single resinous film is formed via screen printing to cover a plurality of surface acoustic wave devices on the parent substrate before cutting, thereby eliminating the need to form a separate resinous film for each of the independent surface acoustic wave devices. Consequently, the cost for forming resinous films is greatly reduced, the process for manufacturing surface acoustic wave devices is greatly simplified, and the cost for manufacturing the surface acoustic wave devices is therefore reduced.

Since insulating powder having a specific gravity of not more than about 1.0 is preferably mixed with resinous material, the properties of the insulating powder are not degraded by resinous films. Since suppression effects of surface acoustic waves decrease when the specific gravity of insulating powder decreases, a volume ratio of an insulating powder having a low specific gravity is higher than that of an insulating powder having a high specific gravity, so that a viscosity suitable for performing screen printing is achieved much more easily.

In addition, bulk waves and unnecessary reflected waves (surface acoustic waves) at edges of the device are suppressed by the resinous film, spurious levels and ripples also are reduced, and characteristics of the surface acoustic wave device are therefore greatly improved.

The SH type surface wave according to preferred embodiments of the present invention is a surface acoustic wave, such as Bleustein-Gulyaev-Shimuzu (BGS) waves and Love waves, the displacement thereof is substantially perpendicular to a propagation direction, and the major component of a surface acoustic wave is substantially parallel to the surface of the substrate. The surface acoustic wave device according to preferred embodiments of the present invention includes general devices using surface acoustic waves, such as surface resonators, and surface acoustic wave filters. Depending on the types and applications, optionally, one or more interdigital transducers may be provided on a piezoelectric substrate.

A gel is a material having low viscosity that cannot be measured by the Shore hardness measurement method, and more particularly, is a material having a penetration number of approximately 100 to 20 measured in accordance with the measurement method for penetration number of the Japanese Industrial Standard (JIS) K 2220. Shore hardness is hardness measured in accordance with the American Society for Testing and Materials (ASTM) D676 or measured by a method similar thereto.

Hereinafter, the preferred embodiments of the present invention are explained in more detail with reference to the drawings.

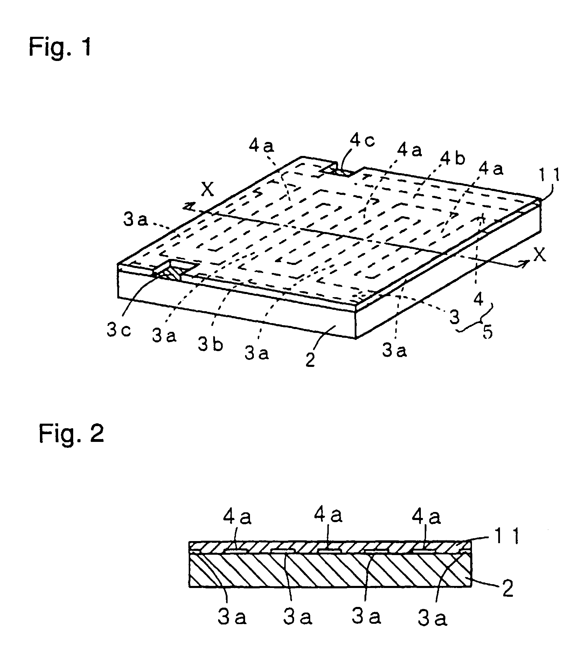

Fig. 1 is a perspective view of a surface acoustic wave device, and Fig. 2 is a cross-sectional view taken along line X-X of the surface acoustic wave device shown in Fig. 1.

The surface acoustic wave device of the present preferred embodiment is an edge reflection type surface acoustic wave resonator including a piezoelectric substrate 2, which preferably has a substantially rectangular shape but can be of any suitable shape. Piezoelectric substrate 2 is preferably made of a piezoelectric material, such as a piezoelectric ceramic of a lead titanate zirconate, LiNbO₃ single crystal, and LiTaO₃ single crystal.

An interdigital transducer 5 (hereinafter referred to as IDT) including a pair of comb-shaped electrodes 3 and 4 is located on one of the primary surfaces of piezoelectric substrate 2, and resinous film 11 is arranged on the entire surface on which the IDT 5 is located, except for portions at which lead electrodes 3c and 4c of IDT 5 are located.

Comb-shaped electrode 3 has a plurality of electrode fingers 3a, and comb-shaped electrode 4 has a plurality of electrode fingers 4a. Lead electrodes 3c and 4c are located at positions of bus bars 3b and 4b of individual comb-shaped electrodes, respectively. According to this preferred embodiment, lead electrodes 3c and 4c are provided on portions extending from bus bars 3b and 4b, respectively. However, the arrangement of the lead electrodes and the locations thereof are not limited to that shown in the figures and described above. For example, portions of the bus bars having desired widths may define the lead electrodes.

Resinous material which preferably includes a mixture of a silicone resin (a silicone rubber) having a Shore hardness of not more than about 30 or in the form of gel, and silica powder having a specific gravity of about 0.03, is coated by screen printing on the entire primary surface of piezoelectric substrate 2 excluding portions where lead electrodes 3c and 4c are located, whereby resinous film 11 is formed. This resinous film 11 is formed and arranged so as to prevent an electrode pattern, such as IDT 5, from being damaged and being contaminated by adhesion of metal powder used in a manufacturing process. In addition, resinous film 11 is arranged to suppress bulk waves and unnecessary reflected waves at edges of the surface acoustic wave device.

Although not shown in the Figures, the surface acoustic wave device is mounted on a base member constituting a package, lead electrodes 3c and 4c are connected to terminal electrodes of the base member preferably by bonding wires, and the base member and a cap member are joined by welding or soldering so as to be hermetically sealed. Instead of using the cap member, a protective resin is coated over the base member.

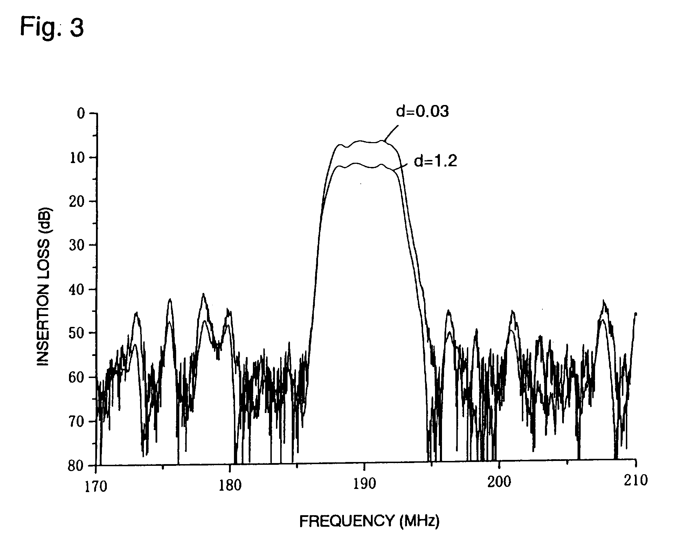

Fig. 3 is a graph showing a frequency characteristic of a longitudinally coupled surface acoustic wave filter according to preferred embodiments of the present invention in which insulating powder having a specific gravity (d) of about 0.03 is used in the resinous film located on the IDTs of the longitudinally coupled surface acoustic wave filter. Fig. 3 also shows a frequency characteristic of a comparative example measured using a longitudinally coupled surface acoustic wave filter in which insulating powder having a specific gravity (d) of about 1.2 is used in the resinous film. As is apparent from Fig. 3, the insertion loss at the passband is much improved when the insulating powder having a specific gravity of about 0.03 is used.

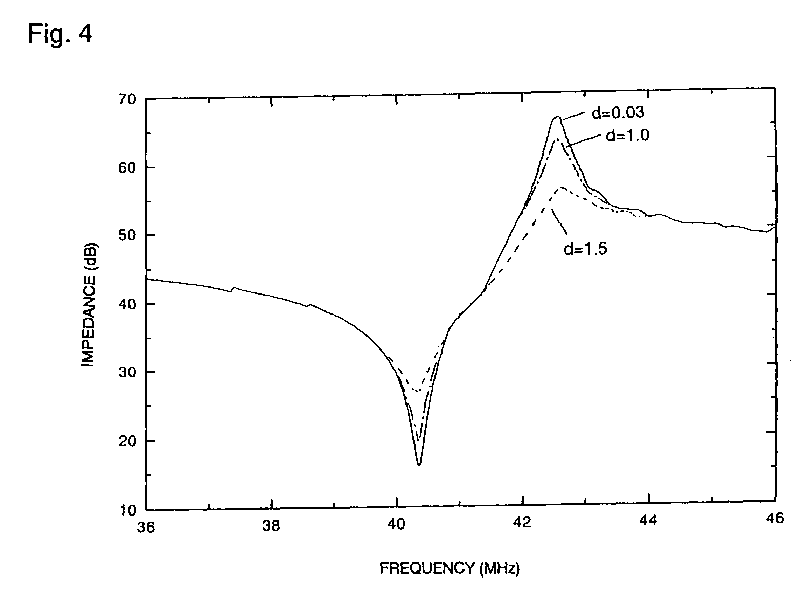

Fig. 4 is a graph showing resonance characteristics of surface acoustic wave resonators according to preferred embodiments of the present invention in which insulating powders having a specific gravities (d) of about 1.0 and about 0.03 are respectively used in the resinous film and a surface acoustic wave resonator according to a comparative example in which insulating powders having a specific gravity (d) of about 1.5 is employed. As is clearly illustrated, when the specific gravity of the insulating powder used in the resinous film becomes small, the impedance ratio (Za/Zr) becomes large.

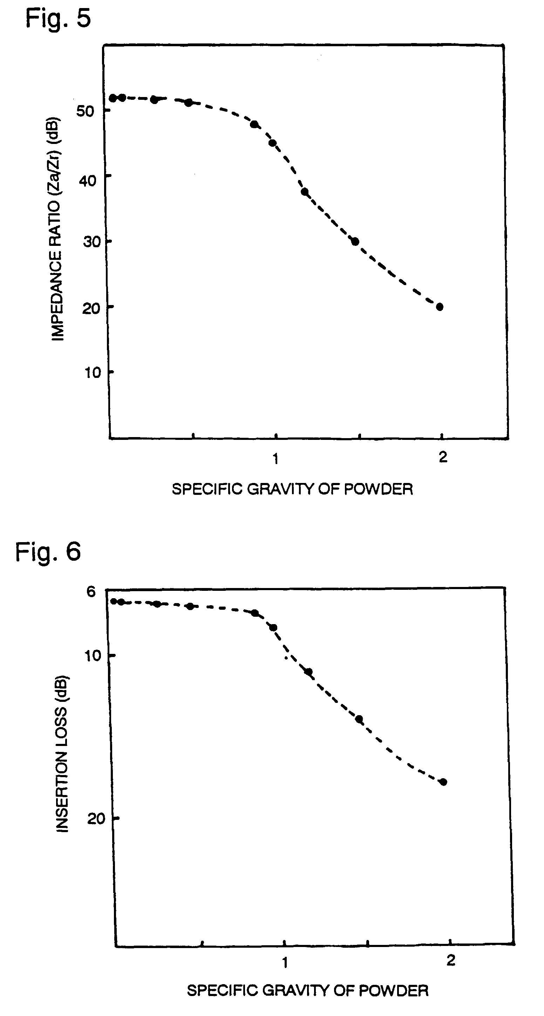

Figs. 5 and 6 respectively show the relationship between the specific gravity of the insulating powder and the impedance ratio and the relationship between the specific gravity of the insulating powder and the insertion loss. It should be understood from these figures that, if the specific gravity of the insulating powder is about 1.0 or less, the impedance ratio and the insertion loss do not degrade substantially. In order to achieve excellent resonance characteristics or filter characteristics, it is preferable that the specific gravity of the insulating powder is about 0.5 or less. For insulating powder having the specific gravity of about 0.5, silica aerogel powder having a specific gravity of about 0.03 to about 0.1 and carbon black powder having a specific gravity of about 0.03 to about 0.5 can be commercially available, for example.

Next, a method for manufacturing the surface acoustic wave device according to preferred embodiments of the present invention will be explained.

A plurality of IDTs shown in Fig. 1, which are surface acoustic wave devices, are aligned and formed on one of the primary surfaces of a large piezoelectric parent substrate. An electrode film preferably made of a conductive electrode material, such as Al or Au, is formed by a thin film forming method, such as deposition, sputtering, or plating, and the electrode film is then exposed and etched so as to form IDTs. Another method for forming IDTs 5 is to form electrode patterns by deposition or sputtering using a mask.

Insulating resinous material is printed preferably using a screen pattern of #200 mesh or other suitable mesh size, over nearly the entire surface of the piezoelectric parent substrate provided with the electrode pattern. The printed resinous material and substrate are then baked, and the formation of the resinous film 11 is thus completed. This resinous material (resinous film 11) is prepared by sufficiently stirring a mixture of insulating powder having a specific gravity of not more than about 1.0 and a resin having a Shore hardness of not more than about 30, or may be in the form of gel. For example, a silicone rubber in the form of gel mixed with a silica powder having a specific gravity of about 0.05 and a grain diameter between approximately 0.1 µm to about 5 µm is used. Portions of the screen pattern used in this case are covered by masks, the portions corresponding to the positions of lead electrodes 3c and 4c of the individual electrode patterns, and resinous film 11 is formed on the parent substrate except at locations of lead electrodes 3c and 4c of the individual electrode patterns. A mixing ratio of insulating powder determined so as to be suitable for performing screen printing is between about 30% and about 60% by weight. In addition to a silicone resin, a urethane resin, a epoxy resin, and a polyester resin may be used as the primary ingredients; and in addition to silica, an aluminum oxide, titanium oxide, or other suitable material, having a specific gravity of not more than about 1.0, may be used as the insulating powder.

Next, by cutting the piezoelectric parent substrate using a cutting tool, such as a dicer, the surface acoustic wave devices shown in Figs. 1 and 2 are obtained. After this process, the surface acoustic wave device is disposed on the base member or on a mounting substrate, and formation of input and output connection is carried out by bonding wires to lead electrodes 3c and 4c.

As described above, in the surface acoustic wave device of this preferred embodiment, the low viscosity of the resinous material is increased by being mixed with insulating powder, and a resinous film is formed by screen printing. That is, resinous films covering a plurality of surface acoustic wave devices provided on the parent substrate before cutting can be formed simultaneously. Consequently, the cost for forming the resinous films is remarkably reduced. In addition, since the resinous films are formed before performing wire bonding, the operation for wire bonding and the like is easily performed, and manufacturing cost is therefore reduced.

Since the insulating powder to be mixed preferably has a specific gravity of not more than 1.0, the optimum viscosity of the resinous material is easily obtained, and degradation of the insulating powder properties due to the resinous films is avoided.

In addition, since the resinous film is formed so as to cover the entire surface of the piezoelectric substrate, bulk waves and unnecessary reflected waves (surface waves) are suppressed, so that spurious levels and ripples are reduced.

In the preferred embodiments described above, the edge reflection type surface wave resonator including one IDT was described as an example; however, an arrangement of the surface acoustic wave device according to the present invention is not so limited. For example, the present invention can be applied to a surface acoustic wave device including a plurality of IDTs connected in a ladder network or to a surface acoustic wave device having an electrode pattern including IDTs and reflectors.

While preferred embodiments of the invention have been disclosed, various modes of carrying out the principles disclosed herein are contemplated as being within the scope of the following claims. Therefore, it is understood that the scope of the invention is not to be limited except as otherwise set forth in the claims.

## Claims

1. A shear horizontal type surface acoustic wave device comprising:
a piezoelectric substrate (2);
an electrode pattern having at least one interdigital transducer (5) and a lead electrode located on the piezoelectric substrate; and
a screen-printed resinous film (11) arranged on the piezoelectric substrate except at locations of the lead electrode (3c,4c) of the electrode pattern.

2. A shear horizontal type surface acoustic wave device according to claim 1, wherein the resinous film (11) includes a mixture of insulating powder and a resin.

3. A shear horizontal type surface acoustic wave device according to claim 2, wherein the insulating powder has a specific gravity of not more than about 1.0.

4. A shear horizontal type surface acoustic wave device according to claim 2, wherein the resin has a Shore hardness of not more than about 30.

5. A shear horizontal type surface acoustic wave device according to claim 2, wherein the resin is a gel resin.

6. A shear horizontal type surface acoustic wave device according to claim 1, further comprising a plurality of interdigital transducers.

7. A shear horizontal type surface acoustic wave device according to claim 2, wherein the resin includes one of a silicone resin, an urethane resin, an epoxy resin, a polyimide resin, and a polyester resin.

8. A shear horizontal type surface acoustic wave device according to claim 2, wherein the insulating powder includes one of silica, aluminum oxide, titanium oxide, carbon black and silica aerogel.

9. A shear horizontal type surface acoustic wave device according to claim 1, wherein the resinous film (11) includes a silicone rubber in the form of gel mixed with a silica powder having a specific gravity of about 0.05 and a grain diameter between approximately 0.1 µm to about 5 µm.

10. A shear horizontal type surface acoustic wave device according to claim 1, wherein the resinous film (11) includes insulating powders having a specific gravity (d) of about 1.0 to about 0.03.

11. A method of forming a surface acoustic wave device comprising the steps of:
providing a parent substrate (2);
forming at least one interdigital transducer (5) on the parent substrate;
forming a resinous film (11) on a surface of the parent substrate except at locations of lead electrodes (3c,4c) of the electrode pattern, the step of forming a resinous film including screen printing the resin film on the surface of the parent substrate; and
cutting the parent substrate (2) to form a plurality of independent surface acoustic wave devices.

12. The method according to claim 11, wherein the step of forming the resinous film (11) includes forming a resinous film including a mixture of insulating powder and a resin.

13. A method according to claim 12, wherein the insulating powder has a specific gravity of not more than about 1.0.

14. A method according to claim 12, wherein the resin has a Shore hardness of not more than about 30.

15. A method according to claim 12, wherein the resin is a gel resin.

16. A method according to claim 11, further comprising the step of forming a plurality of interdigital transducers on the parent substrate (2).

17. A method according to claim 12, wherein the resin includes one of a silicone resin, an urethane resin, an epoxy resin, a polyimide resin, a polyester resin.

18. A method according to claim 12, wherein the insulating powder includes one of silica, aluminum oxide, titanium oxide, carbon black, and silica aerogel.

19. A method according to claim 11, wherein the resinous film (11) includes a silicone rubber in the form of gel mixed with a silica powder having a specific gravity of about 0.05 and a grain diameter between approximately 0.1 µm to about 5 µm.

20. A method according to claim 1, wherein the resinous film (11) includes insulating powders having a specific gravity (d) of about 1.0 to about 0.03.
